# EUROPEAN PATENT SPECIFICATION

(11) **EP 1 835 504 B1**
(45) Date of publication and mention of the grant of the patent: **08.08.2012**
(21) Application number: 06461004.1
(22) Date of filing: 17.03.2006
(51) Int. Cl.: G11B 33/12, G11B 33/08, H05K 7/14

(54) **Attachment assembly for mounting electronic devices**
Montagessatz zum Aufbau von elektronischen Vorrichtungen
Ensemble pour montage des dispositifs électroniques

(43) Date of publication of application: 19.09.2007
(73) Proprietor: Advanced Digital Broadcast S.A., 1292 Pregny-Chambesy (CH)
(72) Inventor: Bozecki, Boguslaw, 65-124, Zielona Gora (PL); Cichonski, Dariusz, 65-001, Zielona Gora (PL); Holub-Gorny, Marek, 66-015, Przylep (PL); Jankowski, Bartosz, 65-119, Zielona Gora (PL); Kajmowicz, Jacek, 66-100, Sulechow (PL); Micewicz, Jaroslaw, 50-457, Wroclaw (PL)
(74) Representative: Pawlowski, Adam

(56) References cited:
- EP-A2- 0 942 428
- US-A1- 2002 044 416
- US-A1- 2005 002 122
- US-B2- 6 496 362
- US-B2- 6 873 524

## Description

The invention concerns an attachment assembly for mounting electronic devices, especially for mounting hard disks drives.

The increased level of complexity of home electronic appliances, such as television set-top boxes, digital video recorders, home media servers, DVD players or personal computers, calls for a careful design of those appliances, taking into account many factors important for their proper operation.

An important issue is an assembly of disk drives, such as optical disk drives or hard disk drives, to provide their proper operating conditions. There are several aspects that should be taken into account, namely isolation of vibrations, protection from mechanical shocks and cooling. The designs should be cost-effective both at manufacturing and assembly stages of the production process.

Disk drives operate at high rotational speeds, which cause vibrations of the drive. The vibrations, if not properly isolated, can be transferred to the housing of the appliance, which may result in a noise highly undesirable by the user. Home appliances are often displaced, for example during house cleaning works. If the displacement occurs during operation of the disk drive and results in a mechanical shock to the device, the disk drive may become damaged. Furthermore, disk drives, especially hard disk drives, emit large amounts of heat, which should be efficiently carried away from the drive.

There have been several attempts of providing a disk drive assembly of electronic devices, but none of them provided all of the aforementioned features.

The Publication of European patent application No. EP 0 942 428 A2 entitled "Shock absorbing holder and information processor having same" presents a shock absorbing holder for holding a device. The holder includes a frame body, a holding portion having shape similar to the device and protruding portions. When shock is given from outside, the protruding portions are deformed to absorb the shock, protecting the device from the shock.

The Publication of US patent application No. US2002/0044416 A1 entitled "Micro hard drive caddy" presents a hard drive caddy, which is provided with a vibration isolation and dampening member disposed between the interior of the frame and the exterior the micro hard drive.

The US patent application No. US2005/0002122 entitled "Hard Disk Cartridge" presents a hard disk drive attachment assembly in which the hard disk is secured by means of a cushion member, which is attached to the hard disk by screws. The mounting of screws is time consuming, which presents a considerable cost of the assembly stage of the production process.

The US patent No. US6,570,7590 entitled "Guide/elector device for computer" presents a hard disk drive attachment assembly utilizing two longitudinal guiding tracks of a shockproof rubbery material, which are to be attached to the sides of the hard disk. They have considerably large dimensions, which results in a considerable production cost. Moreover, since they cover the whole side surface of the hard disk, they limit the cooling efficiency.

The US patent No. US6,882,528 entitled "Suspension-type shock-avoiding structure for a hard disk" presents a hard disk drive attachment assembly comprising a plurality of double-portion fasteners and shock absorbing members which hold the hard disk in position and isolate it from shocks. Due to a large number of components, such solution requires a lot of time to be mounted, which presents a considerable cost of the assembly stage of the production stage. Moreover, large number of elements results in a considerably high cost at the manufacturing stage.

The US patent No. US6,496,362 entitled "Method and apparatus for protecting a hard disk drive from shock" presents a hard disk drive attachment assembly utilizing four resilient elements to be mounted at the corners of the hard disk. The elements are formed from two different materials, which make them relatively expensive to manufacture. Moreover, being mounted at the corners of the drive, they can be mounted only in a casing providing support at corners. This limits the freedom of casing design.

The US patent No. US6,304,440 entitled "Shock-proof device of external hard disk drive box" presents a hard disk drive attachment assembly comprising a fixing block with a plurality of soft protecting pads. The fixing block is to be attached to the hard disk by means of screws. Such solution is neither inexpensive nor easy to mount.

The US patent No. US6,873,524 entitled "Data storage device" presents a hard disk drive attachment assembly utilizing two types of shock-isolating pads. The pads of the first type are L-shaped, and 8 pads are necessary to secure the hard disk. This is both expensive and not easy to mount. The pads of the second type enclose the hard disk both from the top and from the bottom, but they are mounted at the corners, therefore 4 pads are necessary to secure the hard disk. Moreover, they can be mounted only in a casing providing support at all corners.

Therefore, there is a need for a cost-effective assembly of electronic devices, which would provide isolation of vibrations, protection from mechanical shocks and would not limit the design of the case, therefore enabling case design allowing efficient cooling.

The idea of the invention is that in an attachment assembly with a housing for mounting inside at least one electronic device, and with at least one distance element inserted between the housing and the electronic device, the housing comprises a casing with stops being provided at the bottom of sidewalls and a cover whereas the distance element comprises a vertical wall, a top arm and a bottom arm such that the distance element surrounds the electronic device at three sides and is placed in a region adjacent to the stops and is provided with a protrusion extending from a surface facing the electronic device and having a diameter adapted to be inserted in an opening situated in a side wall of the electronic device.

Preferably, the top arm of the distance element is longer than the bottom arm of the distance element to avoid interfering with the electronic circuits on a bottom side of the electronic device and to provide good holding conditions of the electronic device.

In a preferred embodiment, the vertical wall of the distance element has thickness g which is greater than a distance between the side wall of the casing and the electronic device and has height h, which is greater than a distance between a bottom surface of the cover and a surface of stop extending perpendicularly from a side wall of the casing.

Preferably, a vertical axis of symmetry of the distance element and axis of symmetry of the first connecting elements are situated in one plane running perpendicularly to the side wall of the casing. It is advantageous that the casing and the cover has additional walls forming an air channel connected with an inside of the housing as well as that in the casing is mounted a fan causing flow of air stream from the outside of the housing to the electronic device.

Preferably, the casing is provided with first connecting elements and the cover is provided with second connecting elements adapted to be engaged with the first connecting elements wherein the first connecting elements and the second connecting elements are placed in a region adjacent to the placement of the distance elements.

The cover can have openings providing more efficient cooling of the electronic device.

Preferably, the distance element has a top arm which is rounded such as to provide easier airflow over a top surface of the electronic device.

The invention will now be described by way of example and with reference to the accompanying drawings in which:
Fig. 1 shows an exploded perspective view of a first embodiment of an attachment assembly;
Fig. 2 shows an enlarged top plan view of the attachment assembly shown in Fig. 1;
Fig. 3 shows an enlarged cross-section view of the attachment assembly taken according to line A-A shown in Fig. 2;
Fig. 4 shows an enlarged perspective view of a distance element;
Fig. 5 shows an enlarged side view of the distance element shown in Fig. 4;
Fig. 6 shows an exploded perspective view of a second embodiment of an attachment assembly; and
Fig. 7 shows a top plan view of a third embodiment of an attachment assembly.

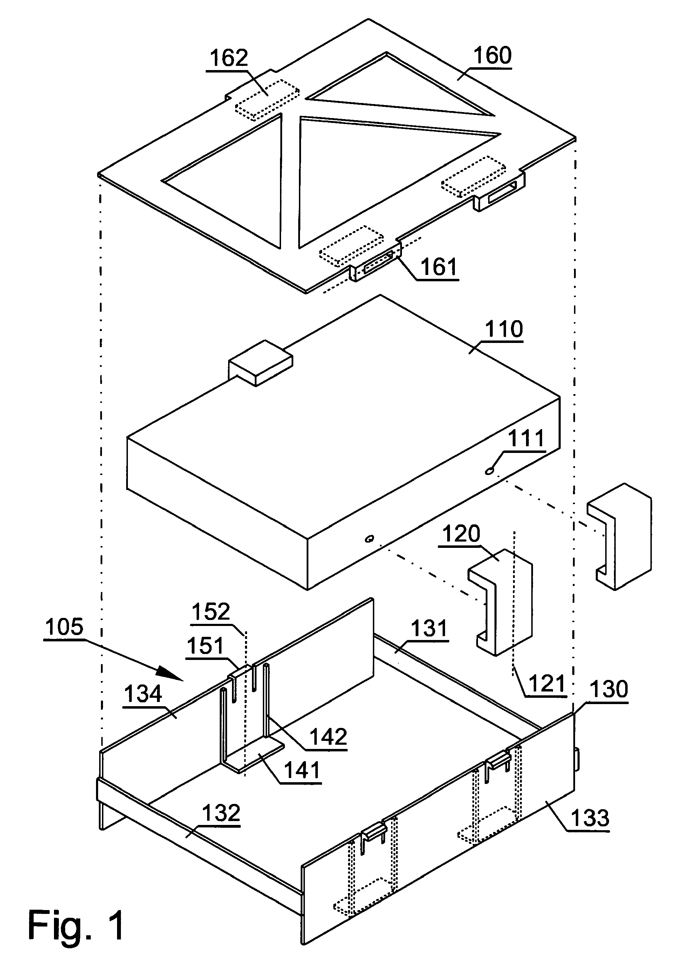

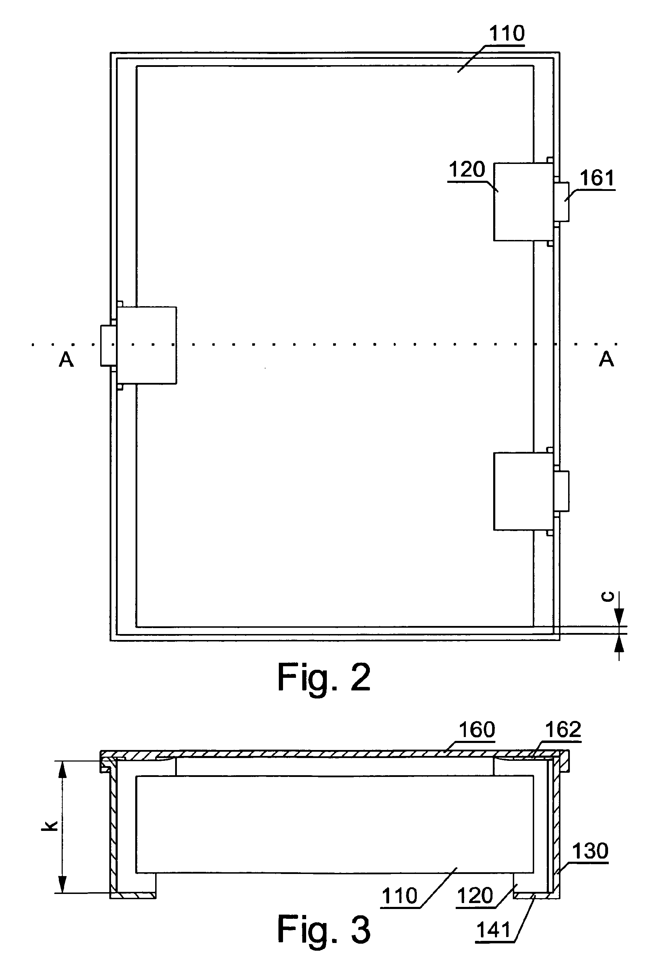

An attachment assembly 100, shown in Figs. 1, 2 and 3, is one of embodiments of assemblies for mounting electronic devices especially for mounting hard disk drives according to the present invention. The attachment assembly comprises a housing 105 and distance elements 120. An inside of the housing 105 substantially matches in form the electronic device, for example a hard disk drive 110, to be placed in. The housing 105 is formed by a casing 130 with first connecting elements 151 and a cover 160 with second connecting elements 161. The distance elements 120 are bracket-shaped or have a form of distance brackets. Preferably, a vertical axis 121 of symmetry of the distance element 120 and an axis 152 of the first connecting elements are situated in one plane running perpendicularly to the side wall 133, 134 of the casing 130.

The casing 130 includes side walls 133, 134 provided at the bottom with stops 141, and side walls 131, 132. Before placing the electronic device in the casing 130, the distance brackets are attached to the hard disk 110 in places matching the stops 141. The casing 133 has additionally slide guides 142 adapted to receive the distance elements 120. In turn, the cover 160 has pads 162 or flat reinforcements in form of beads situated near the second connecting elements 161. The cover has also openings 165, which increase the efficiency of cooling of the hard disk.

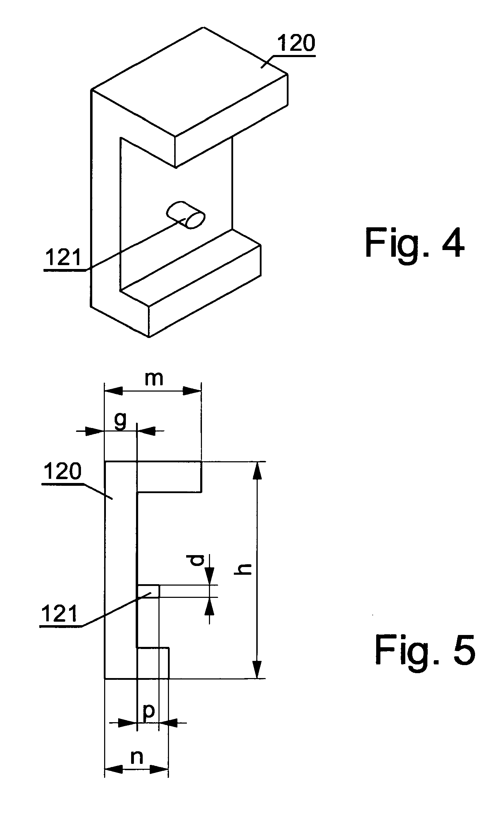

Figs. 4 and 5 present the distance element 120 in details. The distance element 120 has a height *h*, which is shortened by the pads 162 of the cover 160 after the distance element is inserted in the casing 130 and the cover 160 is fastened. A vertical wall of the distance element has thickness *g* which is greater than a distance between the side wall 133, 134 of the casing 130 and the hard disk drive 110, and which is also shortened when the hard disk drive 110 is inserted together with the distance elements 120 into the casing 130. The distance element 120 has a top arm of length *m* and a bottom arm of length *n*. Preferably, the bottom arm is short, in order not to interfere with the electronic circuits on the bottom side of the hard disk. The top arm is long, in order to provide good holding conditions of the hard disk. For example, the bottom arm may have the length *m* of 1cm and the top arm may have the length *n* of 1.5 cm. The distance element 120 has a protrusion 121 in a shape of a pin of a diameter *d* and a length *p.* The protrusion 121 is adapted to be inserted into a hard disk opening 111 for screws, thus providing additional holding force of the disk. The length of the protrusion *p* is greater than the distance *c* between the hard disk drive 110 and the side walls 131, 132 of the casing 130. When the housing is subject to a shock in the direction of the longer dimension of the hard disk, the displacement of the hard disk will be limited by the side walls 131, 132 to the distance *c*, thus preventing the slip-off of the protrusions 121 having length *p* greater than *c.*

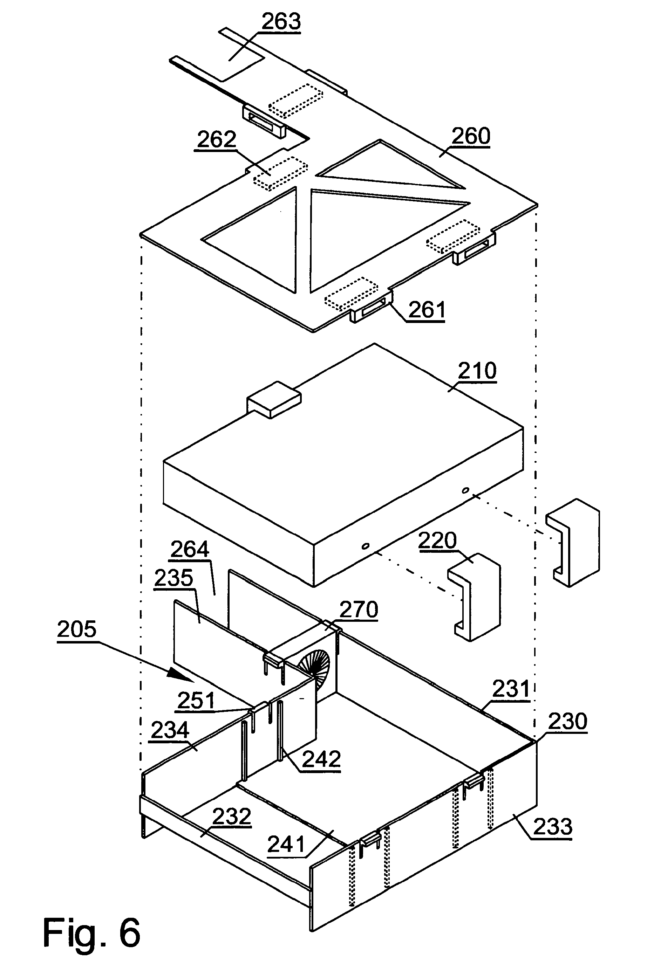

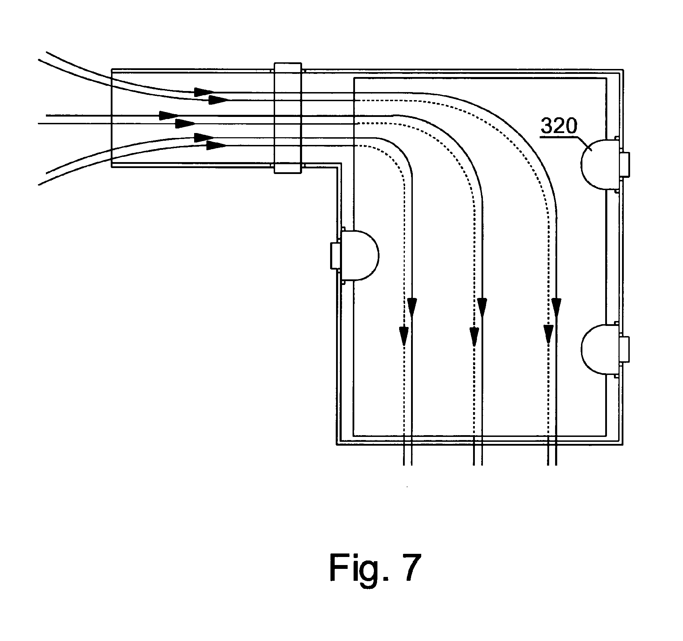

Figs. 6 and 7 show second and third embodiments of attachment assemblies that differ in shape of the top arm of the distance elements 220, 320, namely the distance element 320 shown in Fig. 7 has the top arm which is rounded such as to provide easier airflow over a top surface of the electronic device. The housing of the attachment assembly shown in Fig. 6 consists of a casing 230 and a cover 260 with pads 262, connecting elements 261 and a top air intake 263. The casing 230 has a support plate 241 functioning as a stop for the distance elements 120, an elongated wall 231, side walls 233, 234 with connecting elements 251, a short wall 235 and a cross-bar 232. A part of the elongated wall 231 with adjacent to it the short wall 235 and a part of the support plate 241 form an air channel with a side air intake 264. In the air channel there is inserted a fan 270 which causes flow of air stream from the outside of the housing to both the top and bottom of the hard disk drive, as shown in details in Fig. 7. The air channel has two air intakes, namely the side air intake 264 and the top air intake 263. The housing may have apertures 242, 265 providing air flow outside the housing, which increases the cooling efficiency. The increase in cooling efficiency decreases the workload of the fan - it may operate for shorter periods or at lower speed. The top arm of the distance element 320 is rounded such as to provide easier airflow over the top surface of the electronic device

The placement of the first connecting elements 151 along the symmetry axis of the stops 141 has the advantage that the distance elements 120, when inserted into the casing 130, provide a springing force to the first connecting elements 151, thus making the connection between the first connecting elements 151 and second connecting elements 161 more durable. However, if the material of the casing 130 is elastic enough, the first connecting elements 151 and the second connecting elements 161 can be placed at other positions of the casing.

The placement of pads 162 close to the second connecting elements 161 guarantees maximum force exerted by the pads on the distance elements 120. However, a design with second connecting elements 161 offset from the pads 162 would also provide some force exerted by the pads 162 on the distance elements 120, and thus would also be beneficial.

The embodiments presented have been described in relation to a hard disk drive, but the attachment assembly according to the invention can be used for mounting other electronic devices as well.

The distance elements thanks to their large surface can be made from the material that is soft enough, so they behave as shock and vibration absorbing elements when the disk operates. The distance elements prevent the hard disk drive before damage in case of drop of the appliance. The distance elements can is made of soft, elastic material, such as elastomeric material, silicone rubber, polyutherane or polyether-based polyutherane. The material can have compression characteristic around 35Sh.

The assembly of the hard disk drive is quicker than in case of screws. The cost of these elements is also smaller than the cost of common metal screws. The casing is made from plastic, such as ABS or other thermoplastic material, which considerably reduces the costs in comparison with the metal casing. Moreover, even in case of trembling transfer to the plastic, the hard disk drive works quieter than the hard disk drive mounted in a metal casing.

In addition, the disk is installed in the middle section of the casing, so the air is flowing at its upper and bottom surface, so the efficiency of cooling is improved.

## Claims

1. An attachment assembly with a housing (105, 205) for mounting at least one electronic device (110, 210), and at least one distance element (120, 220) inserted between the housing (105, 205) and the electronic device (110, 210), the housing (105, 205) comprising a casing (130, 230) with stops (141, 241) and a cover (160, 260), the stops (141, 241) being provided at the bottom of sidewalls (133, 134), **characterized in that** the distance element (120, 220) comprises a vertical wall, a top arm and a bottom arm such that the distance element surrounds the electronic device (110, 210) at three sides and is placed in a region adjacent to the stops (141, 241) and is provided with a protrusion (121) extending from a surface facing the electronic device (110, 210) and having a diameter adapted to be inserted in an opening (111) situated in a side wall of the electronic device (110, 210).

2. The attachment assembly according to claim 1, **characterized in that** the top arm of the distance element (120) is longer than the bottom arm of the distance element (120) to avoid interfering with the electronic circuits on a bottom side of the electronic device (110, 210) and to provide good holding conditions of the electronic device (110, 210).

3. The attachment assembly according to claim 1, **characterized in that** the vertical wall of the distance element (120) has thickness g which is greater than a distance between the side wall (133, 134) of the casing (130) and the electronic device (110).

4. The attachment assembly according to claim 1, **characterized in that** the distance element (120) has height h, which is greater than a distance between a bottom surface of the cover and a surface of stop (141, 241) extending perpendicularly from a side wall (133, 134) of the casing (130).

5. The attachment assembly according to claim 1, **characterized in that** a vertical axis (121) of symmetry of the distance element (120) and an axis (152) of the first connecting elements (151) are situated in one plane running perpendicularly to the side wall (133, 134) of the casing (130).

6. The attachment assembly according to claim 1, **characterized in that** the casing (130) and the cover (160) has additional walls forming an air channel (264) connected with an inside of the housing (205).

7. The attachment assembly according to claim 1, **characterized in that** in the casing (130) is mounted a fan (270) and the cover (160) has additional walls forming an air channel (264) causing flow of air stream from the outside of the housing (205) to the electronic device (210).

8. The attachment assembly according to claim 1, **characterized in that** the casing (130, 230) is provided with first connecting elements (151, 251) and the cover (160, 260) is provided with second connecting elements (161, 261) adapted to be engaged with the first connecting elements (151, 251) wherein the first connecting elements (151, 251) and the second connecting elements (161, 261) are placed in a region adjacent to the placement of the distance elements (120, 220).

9. The attachment assembly according to claim 1, **characterized in that** the distance element (320) has a top arm which is rounded such as to provide easier airflow over a top surface of the electronic device (110, 210).

10. The attachment assembly according to claim 1, **characterized in that** the cover (160, 260) has openings (165, 265) providing more efficient cooling of the electronic device.

## Patentansprüche

1. Montagesatz mit einem Gehäuse (105, 205) zum Aufbauen von wenigstens einer elektronischen Vorrichtung (110, 210) und wenigstens einem Abstandselement (120, 220), welches zwischen dem Gehäuse (105, 205) und der elektronischen Vorrichtung (110, 210) eingefügt ist, wobei das Gehäuse (105, 205) eine Hülle (130, 230) mit Stoppelementen (141, 241) und eine Abdeckung (160, 260) umfasst, wobei die Stoppelemente (141, 241) am Boden von Seitenwänden (133, 134) bereitgestellt sind,
**dadurch gekennzeichnet, dass**
das Abstandselement (120, 220) eine vertikale Wand, einen oberen Arm und einen unteren Arm umfasst, so dass das Abstandselement die elektronische Vorrichtung (110, 210) an drei Seiten umgibt und in einem Bereich neben den Stoppelementen (141, 241) angeordnet ist, und mit einem Vorsprung (121) vorgesehen ist, welcher sich von einer der elektronischen Vorrichtung (110, 210) zugewandten Fläche erstreckt und einen Durchmesser aufweist, der dazu eingerichtet ist, in eine Öffnung (111) eingeführt zu werden, welche in einer Seitenwand der elektronischen Vorrichtung (110, 210) gelegen ist.

2. Montagesatz nach Anspruch 1,
**dadurch gekennzeichnet, dass**
der obere Arm des Abstandselements (120) länger als der untere Arm des Abstandselements (120) ist, um ein Beeinträchtigen der elektronischen Schaltungen an einer Bodenseite der elektronischen Vorrichtung (110, 210) zu vermeiden und für gute Halteverhältnisse der elektronischen Vorrichtung (110, 210) zu sorgen.

3. Montagesatz nach Anspruch 1,
**dadurch gekennzeichnet, dass**
die vertikale Wand des Abstandselements (120) eine Dicke g aufweist, welche größer als eine Entfernung zwischen der Seitenwand (133, 134) der Hülle (130) und der elektronischen Vorrichtung (110) ist.

4. Montagesatz nach Anspruch 1,
**dadurch gekennzeichnet, dass**
das Abstandselement (120) eine Höhe h aufweist, welche größer als eine Entfernung zwischen einer Bodenfläche der Abdeckung und einer Fläche eines Stoppelements (141, 241) ist, das sich senkrecht von einer Seitenwand (133, 134) der Hülle (130) erstreckt.

5. Montagesatz nach Anspruch 1,
**dadurch gekennzeichnet, dass**
eine vertikale Symmetrieachse (121) des Abstandselements (120) und eine Achse (152) der ersten Verbindungselemente (151) in einer Ebene liegen, welche senkrecht zur Seitenwand (133, 134) der Hülle (130) verläuft.

6. Montagesatz nach Anspruch 1,
**dadurch gekennzeichnet, dass**
die Hülle (130) und die Abdeckung (160) zusätzliche Wände aufweisen, welche einen mit einem Inneren des Gehäuses (205) verbundenen Luftkanal (264) bilden.

7. Montagesatz nach Anspruch 1,
**dadurch gekennzeichnet, dass**
in der Hülle (130) ein Gebläse (270) montiert ist und dass die Abdeckung (160) zusätzliche Wände aufweist, welche einen Luftkanal (264) bilden, wodurch ein Luftstrom von außerhalb des Gehäuses (205) zu der elektronischen Vorrichtung (210) strömt.

8. Montagesatz nach Anspruch 1,
**dadurch gekennzeichnet, dass**
die Hülle (130, 230) mit ersten Verbindungselementen (151, 251) vorgesehen ist und die Abdeckung (160, 260) mit zweiten Verbindungselementen (161, 261) vorgesehen ist, die dazu eingerichtet sind, mit den ersten Verbindungselementen (151, 251) in Eingriff zu treten, wobei die ersten Verbindungselemente (151, 251) und die zweiten Verbindungselemente (161, 261) in einem Bereich neben der Anordnung der Abstandselemente (120, 220) angeordnet sind.

9. Montagesatz nach Anspruch 1,
**dadurch gekennzeichnet, dass**
das Abstandselement (320) einen oberen Arm aufweist, welcher abgerundet ist, um für eine leichtere Luftströmung über eine obere Fläche der elektronischen Vorrichtung (110, 120) zu sorgen.

10. Montagesatz nach Anspruch 1,
**dadurch gekennzeichnet, dass**
die Abdeckung (160, 260) Öffnungen (165, 265) aufweist, die für ein effizienteres Kühlen der elektronischen Vorrichtung sorgen.

## Revendications

1. Ensemble de fixation avec un logement (105, 205) permettant de monter au moins un dispositif électronique (110, 210) et au moins un élément de distance (120, 220) inséré entre le logement (105, 205) et le dispositif électronique (110, 210), le logement (105, 205) comprenant un boîtier (130, 230) avec des butées (141, 241) et un couvercle (160, 260), les butées (141, 241) étant agencées dans la partie inférieure de parois latérales (133, 134), **caractérisé en ce que** l'élément de distance (120, 220) comprend une paroi verticale, un bras supérieur et un bras inférieur de sorte que l'élément de distance entoure le dispositif électronique (110, 210) au niveau de trois côtés et est placé dans une région adjacente aux butées (141, 241) et est doté d'une saillie (121) s'étendant depuis une surface en regard du dispositif électronique (110, 120) et ayant un diamètre adapté pour être inséré dans une ouverture (111) située dans une paroi latérale du dispositif électronique (110, 120).

2. Ensemble de fixation selon la revendication 1, **caractérisé en ce que** le bras supérieur de l'élément de distance (120) est plus long que le bras inférieur de l'élément de distance (120) afin d'éviter une interférence avec les circuits électroniques sur un côté inférieur du dispositif électronique (110, 120) et pour fournir de bonnes conditions de maintien du dispositif électronique (110,210).

3. Ensemble de fixation selon la revendication 1, **caractérisé en ce que** la paroi verticale de l'élément de distance (120) a une épaisseur g qui est supérieure à une distance entre la paroi latérale (133, 134) du boîtier (130) et le dispositif électronique (110).

4. Ensemble de fixation selon la revendication 1, **caractérisé en ce que** l'élément de distance (120) a une hauteur h, qui est supérieure à une distance entre une surface inférieure du couvercle et une surface de la butée (141, 241) s'étendant perpendiculairement depuis une paroi latérale (133, 134) du boîtier (130).

5. Ensemble de fixation selon la revendication 1, **caractérisé en ce qu'**un axe vertical (121) de symétrie de l'élément de distance (120) et un axe (152) des premiers éléments de raccordement (151) sont situés dans un plan s'étendant perpendiculairement à la paroi latérale (133, 134) du boîtier (130).

6. Ensemble de fixation selon la revendication 1, **caractérisé en ce que** le boîtier (130) et le couvercle (160) ont des parois supplémentaires formant un canal d'air (264) raccordé à un intérieur du logement (205).

7. Ensemble de fixation selon la revendication 1, **caractérisé en ce qu'**un ventilateur (270) est monté dans le boîtier (130) et le couvercle (160) comporte des parois additionnelles formant un canal d'air (264) provoquant un écoulement d'air de l'extérieur du logement (205) vers le dispositif électronique (210).

8. Ensemble de fixation selon la revendication 1, **caractérisé en ce que** le boîtier (130, 230) est doté de premiers éléments de raccordement (151, 251) et le couvercle (160, 260) est doté de seconds éléments de raccordement (161, 261) adaptés pour être mis en prise avec les premiers éléments de raccordement (151, 251), dans lequel les premiers éléments de raccordement (151, 251) et les seconds éléments de raccordement (161, 261) sont placés dans une région adjacente à l'emplacement des éléments de distance (120, 220).

9. Ensemble de fixation selon la revendication 1, **caractérisé en ce que** l'élément de distance (320) comporte un bras supérieur qui est arrondi de façon à permettre un écoulement d'air plus facile sur une surface supérieure du dispositif électronique (110, 210).

10. Ensemble de fixation selon la revendication 1, **caractérisé en ce que** le couvercle (160, 260) comporte des ouvertures (165, 265) permettant un refroidissement plus efficace du dispositif électronique.
